Europäisches Patentamt

European Patent Office

Office européen des brevets

(11) Veröffentlichungsnummer: **0 570 897 A2**

## EUROPÄISCHE PATENTANMELDUNG

(21) Anmeldenummer: **93108046.9**

(22) Anmeldetag: **17.05.93**

(51) Int. Cl.5: **H03G 1/04**, H03G 3/00

(30) Priorität: **20.05.92 DE 4216646**

(43) Veröffentlichungstag der Anmeldung:
**24.11.93 Patentblatt 93/47**

(84) Benannte Vertragsstaaten:
**BE DE FR GB IT NL**

(71) Anmelder: **ANT Nachrichtentechnik GmbH**
**Gerberstrasse 33**
**D-71522 Backnang(DE)**

(72) Erfinder: **Born, Andreas, Dipl.-Ing.**
**Südstrasse 96**
**W-7150 Backnang(DE)**
Erfinder: **Khilla, Abdel-Messiah, Dr. Ing.**
**Welzheimer Strasse 25/1**
**W-7150 Backnang(DE)**

(54) **Anordnung zur Bereitstellung eines Stellsignals für ein Dämpfungsglied.**

(57) Zur Bereitstellung eines Stellsignals für ein Dämpfungsglied (D) über welches die Verstärkung eines Verstärkers (V) einstellbar ist sind drei Netzwerke (N1, N2, N3) vorgesehen, die eine Temperaturkompensation des Verstärkers (V) mitsamt Dämpfungsglied (D) und zwar unabhängig vom Aussteuerungsgrad gestatten. Das erste Netzwerk (N1) bildet den Temperaturgang des Dämpfungsgliedes nach und das zweite Netzwerk (N2) den Temperaturgang des Verstärkers (V). Die Ausgangssignale des ersten und zweiten Netzwerks werden in einem dritten Netzwerk (N3) zur Generierung des Stellsignals linear überlagert.

Diese Anordnung eignet sich zur Temperaturkompensation von Mikrowellenhalbleiterverstärkern mit einer PIN-Diode als Dämpfungsglied (D).

Fig. 1

Die Erfindung betrifft eine Anordnung zur Bereitstellung eines Stellsignals für ein Dämpfungsglied über welches die Verstärkung eines Verstärkers einstellbar ist.

Aus der DE 37 14 984 A1 ist ein Verfahren sowie eine Anordnung zur Temperaturkompensation eines Verstärkers bekannt, welchem zur Verstärkungseinstellung ein Dämpfungsglied vorgeschaltet ist. Dem Dämpfungsglied wird dort ein Stellsignal zugeführt, welches aus der Verknüpfung einer Verstärkersteuerspannung und einem temperaturabhängigen Signal hervorgeht. Diese Anordnung benötigt einen Multiplizierer und einen Temperaturfühler und ist unter Umständen nicht sehr einfach abzugleichen.

Aus Electronic Design News, June 13, 1985, Seite 193 ist eine Anordnung zur Bereitstellung eines Stellsignals für ein Dämpfungsglied in Form einer PIN-Diode bekannt, über welches die Verstärkung eines Verstärkers einstellbar ist. Diese Anordnung besteht aus einer Brückenschaltung mit einem Thermistor in einem Brückenzweig. An die Brückendiagonalen sind Operationsverstärker angeschlossen, deren Ausgangssignale linear zu einem Stellsignal überlagert werden. Diese Anordnung ermöglicht eine Temperatur-Kompensation nur für eine feste Stellgröße.

Eine ähnliche Anordnung zur Temperaturkompensation als Bestandteil einer Regelschleife ist aus der EP 108 409 B1 bekannt. Sie weist zwei Pfade mit temperaturabhängigen Widerständen auf, die beide auf einen Operationsverstärker führen. Auch diese Anordnung gestattet eine Temperaturkompensation nur für eine feste Stellgröße (vorgegebene Verstärkung).

Aufgabe der Erfindung ist es eine Anordnung eingangs genannter Art anzugeben, die eine Temperaturkompensation unabhängig von der vorgegebenen Verstärkung gestattet.

Diese Aufgabe wird durch die Merkmale des Anspruchs 1 gelöst. Die Unteransprüche zeigen vorteilhafte Ausgestaltungen bzw. eine Verwendung auf.

Die Erfindung ist universell verwendbar und nicht auf eine spezielle Art eines Temperaturgangs beschränkt. Die Anordnung ist einfach abgleichbar und kann für andere Verstärker- oder Dämpfungsglieder einfach umgerüstet werden. Auch bei Vorgabe anderer Verstärkungsfaktoren ist die Temperaturkompensation voll wirksam. Mit dem ersten Netzwerk läßt sich der Temperaturgang des Dämpfungsgliedes auch unter Berücksichtigung des temperaturabhängigen Aussteuerungsgrades für das Stellglied erfassen. Die Temperaturgangkurve des Verstärkers kann parallel verschoben werden und mittels des dritten Netzwerkes so zur Temperaturgangkurve des Dämpfungsgliedes gelegt werden, daß sich in jedem Falle, d.h. auch bei Veränderung der Aussteuerung, die Temperaturgänge von Dämpfungsglied und Verstärker kompensieren. Durch ihren einfachen Aufbau ist die Anordnung miniaturisierbar bzw. einfach integrationsfähig.

Anhand der Zeichnungen werden Ausführungsbeispiele der Erfindung näher erläutert. Es zeigen

Figur 1 den Stromlauf einer Anordnung nach der Erfindung,

Figur 2 die temperaturabhängige Dämpfung des Dämpfungsgliedes für drei verschiedene Temperaturen,

Figur 3 die temperaturabhängige Ausgangsspannung des Netzwerkes N1,

Figur 4 die temperaturabhängige Ausgangsspannung des Netzwerkes N2,

Figur 5 den temperaturabhängigen Verlauf des Stellsignals für das Dämpfungsglied,

Figur 6 den aussteuerungsabhängigen Temperaturgang eines Verstärkers, wenn dessen Stellglied (PIN)-Diode) im linearen Bereich arbeitet,

Figur 7 den aussteuerungsabhängigen Temperaturgang eines Verstärkers, wenn dessen Stellglied (PIN-Diode) nahe der Kompression arbeitet,

Figur 8 den Stromlauf einer Anordnung nach der Erfindung mit der Möglichkeit der Parallelverschiebung der Nachbildung der Temperaturgangkurve des Verstärkers in zwei Richtungen und

Figur 9 den Stromlauf einer Anordnung nach der Erfindung ohne Einstellmöglichkeit der Verstärkung.

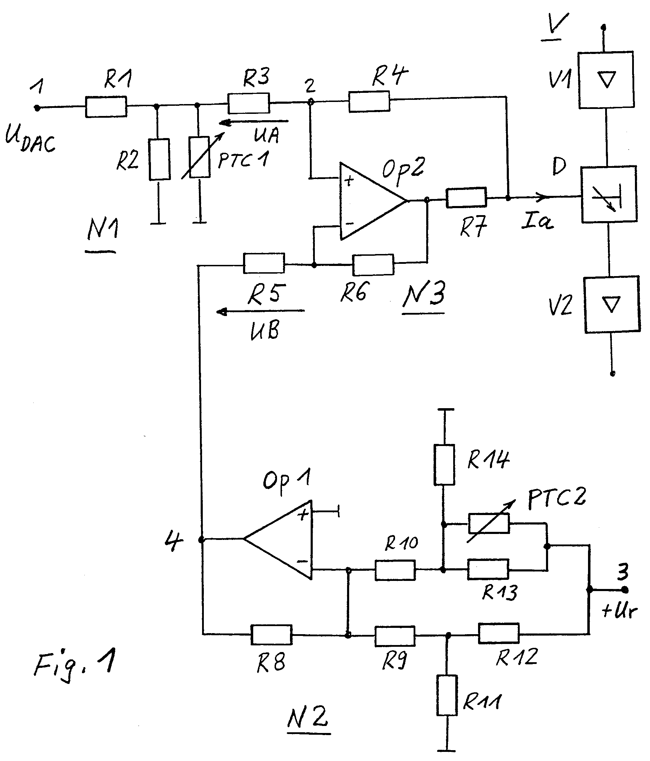

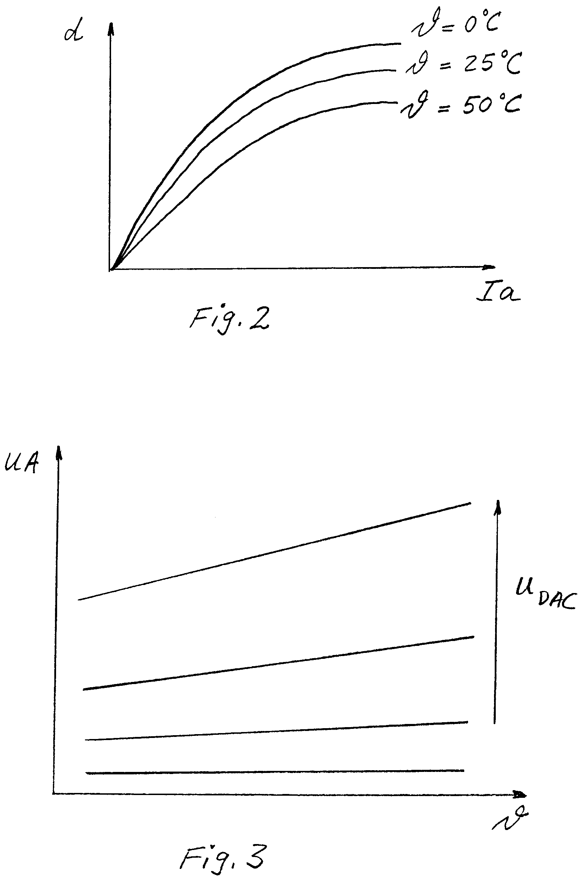

Der in Figur 1 beispielhaft dargestellte Verstärker V, z.B. ein Mikrowellenverstärker, besteht aus zwei in Kette geschalteten Verstärkerstufen V1 und V2, zwischen denen ein einstellbares Dämpfungsglied, z.B. ein stromsteuerbares PIN-Dioden Dämpfungsglied, zur Einstellung der Verstärkung des Verstärkers V angeordnet ist. Dem Dämpfungsglied D wird ein Stellsignal in Form eines Stromes Ia zugeführt. Dieses Stellsignal Ia wird über die Netzwerke N1, N2 und N3 aus einer variablen Spannung $U_{DAC}$, welche der Eingangsklemme 1 des Netzwerkes N1 zugeführt ist, abgeleitet, die ein Maß für die einstellbare Verstärkung des Verstärkers V darstellt. Das Stellsignal Ia ist somit eine Funktion der Spannung $U_{DAC}$ aber auch eine Funktion der Temperatur $\vartheta$, der in den Netzwerken N1 und N2 enthaltenen temperaturabhängigen Widerstände. Die Netzwerke N1 und N2 sind zusammen mit dem Netzwerk N3 so aufgebaut und dimensioniert, daß die unterschiedlichen auch aussteuerungsabhängigen Temperaturgänge von Dämpfungsglied D und Verstärker V bei jeder mittels $U_{DAC}$ einstellbaren Verstärkung kompensiert werden. Anhand der Figuren 2 bis 7 wird diese Temperaturkompensation näher erläutert.

Figur 2 zeigt die Dämpfung d des HF-Pegels durch das Dämpfungsglied D in Abhängigkeit des Stromes Ia für drei verschiedene Temperaturen $\theta = 0°$, $25°$ und $50°$ C. Das Netzwerk N1, dessen Übertragungsfunktion den Temperaturgang der Dämpfung d des Dämpfungsgliedes D nachbildet, liefert die

2

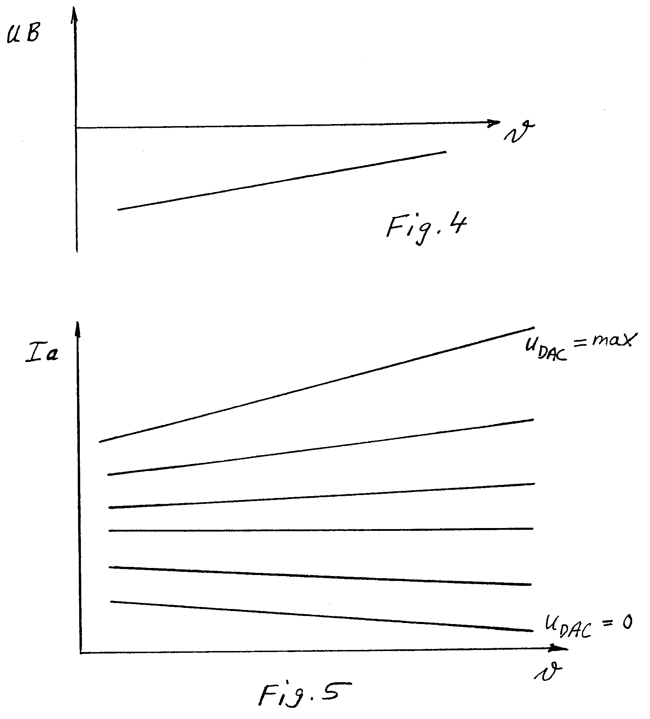

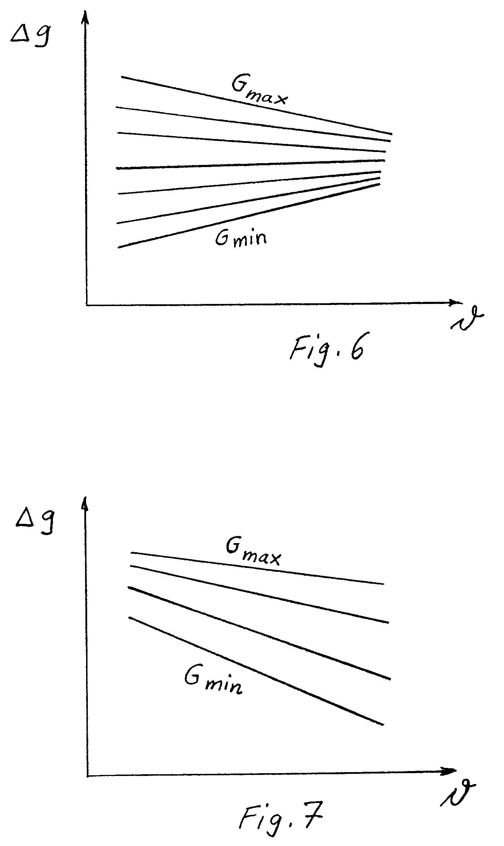

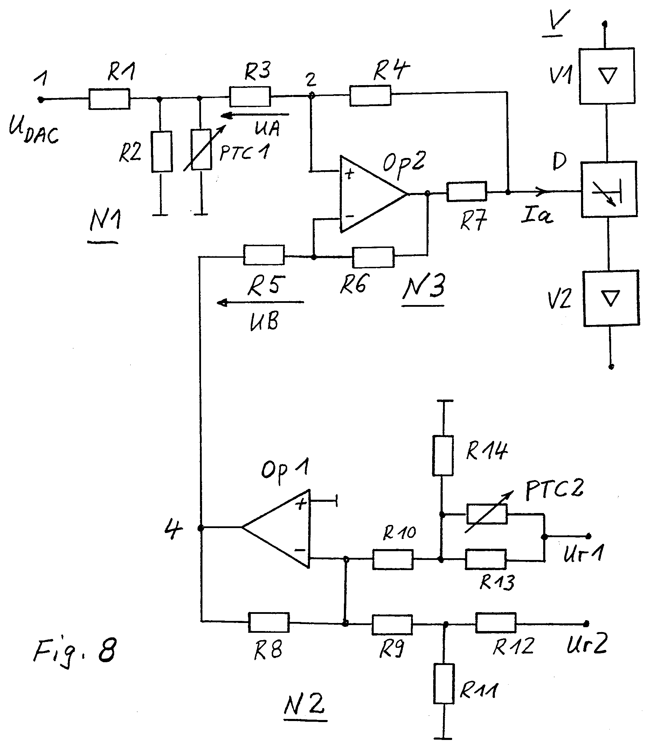

in Figur 3 dargestellte temperaturabhängige Ausgangsspannung UA an Klemme 2, bzw. am Widerstand R3. Wie Figur 3 zeigt ist dies eine Schar von monoton ansteigenden Geraden, deren Steigung mit wachsender Spannung $U_{DAC}$ zunimmt. Das Netzwerk N2, dessen Übertragungsfunktion den Temperaturgang des Verstärkers V nachbildet, liefert ausgangsseitig - Spannungsabfall am Widerstand R5 - die temperaturabhängige Ausgangsspannung UB, die gegenüber der Ausgangsspannung UA ein anderes Vorzeichen aufweist, jedoch ebenfalls aus einer monoton steigenden Geraden besteht (Figur 4). Werden die in den Figuren 3 und 4 gezeigten Temperaturgänge mittels dem Netzwerk N3, welches aus einer Stromquelle mit Subtrahiereingängen besteht, linear zum Stellsignal Ia überlagert, entsteht die in Figur 5 dargestellte aussteuerungsabhängige Schar von Temperaturgängen, wobei die untere Gerade den Parameter $U_{DAC} = 0$ (entspricht der maximalen Verstärkung des Verstärkers V) aufweist und die obere Gerade den Parameter $U_{DAC}$ = max, z.B. 5V (entspricht der minimalen Verstärkung des Verstärkers V nahe der Kompression). Mit einem solchen Stellsignal können die in den Figuren 6 und 7 dargestellten Temperaturgänge von Halbleiterverstärkern kompensiert werden. Die Figuren 6 und 7 zeigen die Verstärkungsabweichung $\Delta$ g in Abhängigkeit der Temperatur ϑ mit der Verstärkung G als Parameter, wobei $G_{min}$ die betriebsmäßig einstellbare minimale Verstärkung angibt und $G_{max}$ die betriebsmäßig einstellbare maximale Verstärkung. Bei Figur 6 arbeitet das Dämpfungsglied im linearen Bereich und bei Figur 7 nahe der Kompression. Der Verstärker nach Figur 7 kann temperaturkompensiert werden, wenn der PTC-Widerstand PTC1 durch einen NTC-Widerstand ersetzt wird.

Das Netzwerk N1, dessen Eingangsklemme 1 mit der variablen Spannung $U_{DAC}$ als Maß für die einstellbare Verstärkung des Verstärkers V beaufschlagt ist, weist in seinem Längszweig zwei ohmsche Serienwiderstände R1 und R3 auf. Im Querzweig, d.h. zwischen dem Verbindungspunkt der Serienwiderstände R1 und R3 und Masse befindet sich ein PTC-Widerstand PTC1, dem gegebenenfalls ein ohmscher Widerstand R2 parallel geschaltet ist. Je nach der Temperaturfunktion des Dämpfungsgliedes D kann der PTC-Widerstand durch einen NTC-Widerstand ersetzt werden. Aus dem gleichen Grunde können die Bauelemente im Längs- und Querzweig gegeneinander vertauscht werden. Die Temperaturfunktion des Dämpfungsgliedes D wird somit durch die Bauelemente R1, R2, PTC1 nachgebildet.

Zur Nachbildung der Temperaturfunktion des Verstärkers ist das Netzwerk N2 vorgesehen. Im Längszweig ist die Serienschaltung zweier ohmscher Widerstände R10 und R13 vorgesehen. Im Querzweig, d.h. zwischen dem Verbindungspunkt der Serienwiderstände R10 und R13 und Masse befindet sich ein ohmscher Widerstand R14. Dem Widerstand R13, der zum Eingang des Netzwerkes N2 weist, ist ein PTC-Widerstand PTC2 parallel geschaltet. Die Eingangsklemme 3 des Netzwerkes N2 ist mit einer festen Referenzspannung Ur beaufschlagt.

Die Temperaturfunktion des Verstärkers wird mit den Bauelementen R13, R14 und PTC2 nachgebildet. Zum Pfad des Längszweiges ist ein Parallelpfad in Form eines ohmschen Spannungsteilers mit den Widerständen R11, R12 vorgesehen. Ein Operationsverstärker Op1 mit den Summierwiderständen R10 und R9 sowie dem Gegenkopplungswiderstand R8 stellt einen invertierenden Addierer für die beiden Pfadsignale dar. Mit dem Spannungsteiler R11, R12 wird ein bestimmter Offsetwert realisiert, d.h. die Lage der Temperaturkurve in Figur 4 läßt sich dadurch, ohne die Steigung zu ändern, parallel verschieben. Es gelten mit R8 = R9 = R10 folgende Beziehungen:

Spannung am Ausgang des Netzwerkes N2:

$$U_{ON2} = - (U_{R11} + U_{R14}),$$

Nachbildung des Temperaturgangs des Verstärkers V:

$$U_{R14} = Ur \cdot \frac{R14}{\dfrac{R13 \cdot R_{PTC2}}{R13 + R_{PTC2}} + R14} \, ,$$

Parallelverschiebung der Temperaturkurve des Verstärkers V ohne Beeinflussung der Steigung:

$$U_{R11} = Ur \cdot \frac{R11}{R11 + R12 .}$$

Die Bauelemente im Längs- und Querzweig des Netzwerkes N2 können entsprechend zum Netzwerk N1 gegeneinander vertauscht werden. Ebenso kann der PTC-Widerstand durch einen NTC-Widerstand ersetzt werden.

Für die Nachbildung der Temperaturfunktion des Netzwerkes N1 gilt:

$$U_{PTC1} = U_{DAC} \cdot \frac{\dfrac{R2 \cdot R_{PTC1}}{R2 + R_{PTC1}}}{\dfrac{R2 \cdot R_{PTC1}}{R2 + R_{PTC1}} + R1}$$

Das Netzwerk N3, welches zur linearen Überlagerung der Ausgangssignale der beiden Netzwerke N1 und N2 dient, besteht aus einer einen Operationsverstärker Op2 enthaltenden Stromquellenschaltung, die aus Tietze/Schenk, Halbleiterschaltungstechnik, 2. Auflage 1971, Seiten 209 und 210 bekannt ist. Mittels des dritten Netzwerkes N3 werden die vom ersten und zweiten Netzwerk N1 und N2 abgebbaren Ausgangssignale in dem Sinne linear überlagert, daß die temperaturabhängigen Steigungen der Übertragungsfunktionen von Dämpfungsglied D und Verstärker V in einem vorgegebenen Bereich anabhängig von der Aussteuerung kompensierbar sind.

Der Ausgang 2 des Netzwerks N1 führt zum nichtinvertierenden Eingang des Operationsverstärkers Op2 und der Ausgang 4 des Netzwerks N2 über den Widerstand R5 zum invertierenden Eingang dieses Operationsverstärkers Op2.

Für den Ausgangsstrom Ia gilt nach Tietze/Schenk:

$$Ia = \frac{U_{PTC1} - U_{ON2}}{R7}$$

Die zuvor aufgestellten Beziehungen für $U_{PTC1}$ und $U_{ON2}$ können in letztere Formel eingesetzt werden, um die Übertragungsfunktion des Gesamtnetzwerkes zu erhalten.

Mit der Anordnung gemäß Figur 8, die getrennte Referenzsignale Ur1 und Ur2 für die beiden Pfade des Netzwerkes N2 enthält, kann die Temperaturkurve des Verstärkers in zwei Richtungen parallel verschoben werden, da die Spannung Ur2 positiv oder negativ sein kann. Es gilt für diese Anordnung:

$$Ia = \frac{U_{DAC} \cdot \dfrac{R2 \cdot R_{PTC1}/(R2+R_{PTC1})}{R2 \cdot R_{PTC1}/(R2+R_{PTC1})+R1}}{R7} -$$

$$\frac{- Ur2 \cdot \dfrac{R11}{R11+R12} \quad - UR1 \cdot \dfrac{R14}{R13 \cdot R_{PTC2}/(R13+R_{PTC2}) + R14}}{R7} \cdot$$

4

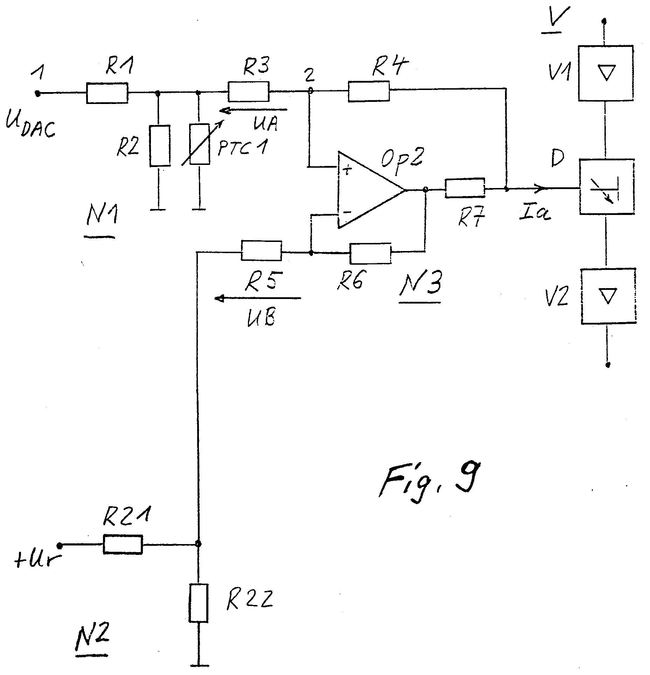

Wenn eine Einstellmöglichkeit der Verstärkung, z.B. für einen Regelbetrieb des Verstärkers, nicht gefordert ist, kann der Aufwand erheblich reduziert werden. Im Gegensatz zur Realisierung nach Figur 1 besteht beim Ausführungsbeispiel gemäß Figur 9 das zweite Netzwerk anstelle des Operationsverstärkers Op1 mit seiner Beschaltung u.a. mit dem temperaturabhängigen Widerstand PTC2 nur aus dem Spannungsteiler R21,R22, der mit der Referenzspannung Ur beaufschlagt ist. Wie mit den Widerständen R11,R12 ist hier mit den Widerständen R21,R22 eine Parallelverschiebung möglich.

**Patentansprüche**

1. Anordnung zur Bereitstellung eines Stellsignals für ein Dämpfungsglied (D) über welches die Verstärkung eines Verstärkers (V) einstellbar ist, wobei die Anordnung aus folgenden Baugruppen besteht:
   - einem ersten Netzwerk (N1), dessen Übertragungsfunktion zumindest den Temperaturgang der Dämpfung des Dämpfungsgliedes (D) auch unter Berücksichtigung des temperaturabhängigen Aussteuerungsgrades für das Dämpfungsglied (D) nachbildet,
   - einem zweiten Netzwerk (N2), welches eine Paralellverschiebung der Temperaturkurve des Verstärkers (V) ermöglicht,
   - einem dritten Netzwerk (N3) zur linearen Überlagerung der vom ersten und zweiten Netzwerk (N1, N2) abgebbaren Ausgangssignale.

2. Anordnung nach Anspruch 1, gekennzeichnet durch folgende Ausbildung des ersten Netzwerkes (N1):
   - im Längszweig des ersten Netzwerkes (N1) zwischen der mit einem veränderbaren und als Maß für die Verstärkung dienenden Signal ($U_{DAC}$) beaufschlagten Eingangsklemme (1) und Ausgang (2) ist mindestens ein ohmscher Widerstand (R1) vorgesehen,
   - im Querzweig ist ein temperaturabhängiger Widerstand (PTC1) vorgesehen, dem gegebenenfalls ein ohmscher Widerstand (R2) parallel geschaltet ist.

3. Anordnung nach Anspruch 1 oder 2, dadurch gekennzeichnet, daß das dritte Netzwerk (N3) aus einem mit einem Referenzsignal (Ur) beaufschlagten Spannungsteiler (R21,R22) besteht, welcher mit dem zweiten Netzwerk (N2) so verbunden ist, daß sich die Temperaturkurve des Verstärkers (V) ohne Änderung der Steigung parallel verschieben läßt.

4. Anordnung nach Anspruch 2, dadurch gekennzeichnet, daß der temperaturabhängige Widerstand (PTC1) ein PTC- oder ein NTC-Widerstand ist.

5. Anordnung nach einem der Ansprüche 1 bis 4, gekennzeichnet durch folgende Ausbildung des zweiten Netzwerkes (N2):
   - im Längszweig des zweiten Netzwerkes (N2) zwischen der mit einem Referenzsignal (Ur; Ur1, Ur2) beaufschlagten Eingangsklemme (3) und den Ausgang (4 bzw. 4') ist mindestens ein erster Pfad mit einem temperaturabhängigen Widerstand (PTC2) vorgesehen, dem ein ohmscher Widerstand (R13) parallel geschaltet ist,
   - im Querzweig ist ein ohmscher Widerstand (R14) vorgesehen.

6. Anordnung nach einem der Ansprüche 3 bis 5, dadurch gekennzeichnet, daß das zweite Netzwerk (N2) einen zum ersten Pfad gelegenen Parallelpfad (R9, R12, R11) aufweist, der ausgangsseitig mit dem ersten Pfad zusammengeschaltet ist und aus dem Spannungsteiler (R11,R12; R21,R22) besteht.

7. Anordnung nach Anspruch 6, dadurch gekennzeichnet, daß die beiden Pfade eingangsseitig von dem Referenzsignal (Ur) gemeinsam oder von zwei voneinander getrennten Referenzsignalen (Ur1, Ur2) beaufschlagbar sind.

8. Anordnung nach einem der Ansprüche 1 bis 7, gekennzeichnet durch die Vertauschung der Bauelemente des ersten Netzwerkes (N1) und/oder des ersten Pfades im zweiten Netzwerk (N2) bezüglich Längs- und Querzweig.

9. Anordnung nach Anspruch 7 oder 8, dadurch gekennzeichnet, daß die beiden Pfade des zweiten Netzwerkes (N2) gemeinsam auf den Subtrahiereingang eines ersten Operationsverstärkers (Op1) geführt sind.

**10.** Anordnung nach einem der Ansprüche 1 bis 9, dadurch gekennzeichnet, daß das dritte Netzwerk (N3) als Stromquelle ausgebildet ist, die einen Operationsverstärker (Op2) enthält, wobei der nichtinvertierende Eingang dieses Operationsverstärkers mittelbar oder unmittelbar mit dem Ausgang (2) des ersten Netzwerkes (N1) verbunden ist und wobei der invertierende Eingang mittelbar oder unmittelbar mit dem Ausgang (4, 4') des zweiten Netzwerkes (N2) verbunden ist.

**11.** Verwendung der Anordnung nach einem der Ansprüche 1 bis 10 für einen Mikrowellenhalbleiterverstärker mit einem Stellglied in Form einer PIN-Diode.

6

Fig. 1

Fig. 2

Fig. 3

UB

Fig.4

Ia

$u_{DAC} = max$

$u_{DAC} = 0$

Fig.5

Fig. 6

Fig. 7

Fig. 8

Fig. 9